# EUROPEAN PATENT APPLICATION

(11) **EP 4 776 011 A1**
(43) Date of publication of application: **15.07.2026**
(21) Application number: 25864554.8
(22) Date of filing: 08.08.2025
(51) Int. Cl.: G01R 31/392, G01R 31/396, G01R 31/367, G01R 31/382, G01R 19/165, H02J 7/00, H01M 10/0525, H01M 10/48

(54) **BATTERY DIAGNOSTIC DEVICE AND BATTERY DIAGNOSTIC METHOD**

(30) Priority: 18.10.2024 KR 20240142734
(71) Applicant: LG ENERGY SOLUTION, LTD., Seoul 07335 (KR)
(72) Inventor: KIM, Tae Hyeon, Daejeon 34122 (KR); KIM, Young Deok, Daejeon 34122 (KR); CHOI, Hyun Jun, Daejeon 34122 (KR)
(74) Representative: Goddar, Heinz J.
(86) International application number: PCT/KR2025/012037
(87) International publication number: WO 2026/084213

(57) **Abstract**

According to an embodiment disclosed in this document, there is provided a battery diagnosis device including an interface configured to acquire a capacity profile representing a voltage with respect to a capacity of a battery cell including an electrode based on a lithium iron phosphate (LFP) material and at least one processor, in which the at least one processor is configured to acquire a first differential capacity profile representing a capacity change of the battery cell with respect to a voltage change of the battery cell, divide an entire voltage range included in the first differential capacity profile into one or more voltage ranges, and identify positive electrode degradation of the battery cell based on a first voltage range among the one or more voltage ranges.

## Description

### TECHNICAL FIELD

### Cross-reference to Related Applications

This application claims priority from Korean Patent Application No. 10-2024-0142734, filed on October 18, 2024, the disclosure of which is incorporated by reference herein.

### Technical Field

Embodiments disclosed in this document relate to a battery diagnosis device and a battery diagnosis method.

### BACKGROUND ART

The degree of degradation of a battery cell may be composed of the sum of an available lithium loss rate and a positive electrode capacity loss rate. By identifying changes in one or more peak values in a capacity profile used during battery cell diagnosis, the degree of positive electrode degradation of the battery cell can be quantified. However, in the case of a battery cell containing lithium iron phosphate (LFP) material, since a characteristic peak does not exist, there is a problem in that quantitative diagnosis of cathode degradation is difficult. Accordingly, a method for determining positive electrode degradation of the battery cell using a voltage related to the positive electrode of the battery cell through differential analysis of a capacity profile of the battery cell using the characteristics of materials in the battery cell may be required.

### DISCLOSURE OF THE INVENTION

### TECHNICAL PROBLEM

Embodiments disclosed in this document provide a battery diagnosis device and a battery diagnosis method for identifying the degree of degradation of a material within a battery cell.

Embodiments disclosed in this document provide a battery diagnosis device and a battery diagnosis method for identifying positive electrode degradation of the battery cell using a slope of a differential capacity profile.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including an interface configured to acquire a capacity profile representing a voltage with respect to a capacity of a battery cell including an electrode based on a lithium iron phosphate (LFP) material and at least one processor, in which the at least one processor is configured to acquire a first differential capacity profile representing a capacity change of the battery cell with respect to a voltage change of the battery cell, divide an entire voltage range included in the first differential capacity profile into one or more voltage ranges, and identify positive electrode degradation of the battery cell based on a first voltage range among the one or more voltage ranges.

For example, the at least one processor may be configured to identify at least one peak included in the first differential capacity profile, identify the first voltage range including a voltage exceeding a first voltage value corresponding to the at least one peak among the one or more voltage ranges, and identify the positive electrode degradation of the battery cell based on the first voltage range.

For example, the at least one processor may be configured to acquire a second differential capacity profile representing the capacity change of the battery cell with respect to the voltage change of the battery cell in a beginning of life (BoL) state, identify a first characteristic section in which a slope of the second differential capacity profile changes in the first voltage range of the second differential capacity profile, and identify the positive electrode degradation of the battery cell based on whether a second characteristic section corresponding to the first characteristic section is identified in the first differential capacity profile.

For example, the at least one processor may be configured to identify the positive electrode degradation of the battery cell exceeding a designated degree of degradation when the second characteristic section is not identified in the first differential capacity profile.

For example, the at least one processor may be configured to identify a second voltage value included in the first characteristic section and a first differential capacity value corresponding to the second voltage value in the second differential capacity file, identify a third voltage value corresponding to the second voltage value and a second differential capacity value corresponding to the third voltage value in the first differential capacity file, identify the positive electrode degradation of the battery cell exceeding the designated degree of degradation when a ratio of the first differential capacity value and the second differential capacity value exceeds the designated degree of degradation, and adjust a charging speed for charging the battery cell based on identifying the positive electrode degradation of the battery cell that exceeds the degree of degradation.

For example, the at least one processor may be configured to identify the positive electrode degradation of the battery cell that is less than the designated degree of degradation when the second characteristic section is identified in the first differential capacity profile.

For example, the at least one processor may be configured to identify the positive electrode degradation of the battery cell based on a slope of the first differential capacity profile included in the first voltage range.

For example, the at least one peak may indicate a phase transition of a negative electrode of the battery cell.

For example, the at least one processor may be configured to acquire the first differential capacity profile representing the capacity change of the battery cell with respect to the voltage change of the battery cell according to the one or more voltage ranges, based on interpolation.

According to an embodiment disclosed in this document, there is provided a battery diagnosis method including an operation of acquiring a first differential capacity profile representing a capacity change of a battery cell including an electrode based on a lithium iron phosphate (LFP) material with respect to a voltage change of the battery cell, an operation of dividing an entire voltage range included in the first differential capacity profile into one or more voltage ranges, and an operation of identifying positive electrode degradation of the battery cell based on a first voltage range among the one or more voltage ranges.

For example, the operation of identifying the positive electrode degradation of the battery cell may include an operation of identifying at least one peak included in the first differential capacity profile, an operation of identifying the first voltage range including a voltage exceeding a first voltage value corresponding to the at least one peak among the one or more voltage ranges, and an operation of identifying the positive electrode degradation of the battery cell based on the first voltage range.

For example, the operation of identifying the positive electrode degradation of the battery cell may include an operation of acquiring a second differential capacity profile representing the capacity change of the battery cell with respect to the voltage change of the battery cell in a beginning of life (BoL) state, an operation of identifying a first characteristic section in which a slope of the second differential capacity profile changes in the first voltage range of the second differential capacity profile, and an operation of identifying the positive electrode degradation of the battery cell based on whether a second characteristic section corresponding to the first characteristic section is identified in the first differential capacity profile.

For example, the operation of identifying the positive electrode degradation of the battery cell may include an operation of identifying the positive electrode degradation of the battery cell exceeding a designated degree of degradation when the second characteristic section is not identified in the first differential capacity profile.

For example, the operation of identifying the positive electrode degradation of the battery cell exceeding the designated degree of degradation may include an operation of identifying a second voltage value included in the first characteristic section and a first differential capacity value corresponding to the second voltage value in the second differential capacity file, an operation of identifying a third voltage value corresponding to the second voltage value and a second differential capacity value corresponding to the third voltage value in the first differential capacity file, an operation of identifying the positive electrode degradation of the battery cell exceeding the designated degree of degradation when a ratio of the first differential capacity value and the second differential capacity value exceeds the designated degree of degradation, and an operation of adjusting a charging speed for charging the battery cell based on identifying the positive electrode degradation of the battery cell that exceeds the degree of degradation.

For example, the operation of identifying the positive electrode degradation of the battery cell may include an operation of identifying the positive electrode degradation of the battery cell that is less than the designated degree of degradation when the second characteristic section is identified in the first differential capacity profile.

### ADVANTAGEOUS EFFECTS

The battery diagnosis device and battery diagnosis method disclosed in this document can identify the degree of degradation of a material within a battery cell.

The battery diagnosis device and battery diagnosis method disclosed in this document can identify the positive electrode degradation of the battery cell using the slope of the differential capacity profile.

In addition, various effects that are directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram illustrating the configuration of a battery diagnosis device according to an embodiment disclosed in this document.
FIG. 3 illustrates an example of a graph representing data related to a battery cell acquired by a battery diagnosis device according to an embodiment disclosed in this document.
FIG. 4 illustrates an example of a graph representing a differential capacity profile acquired by a battery diagnosis device according to an embodiment disclosed in this document.
FIG. 5 illustrates an example of a graph showing a differential capacity profile according to discharging of a battery cell according to an embodiment disclosed in this document.
FIG. 6 illustrates an example of a flowchart showing operations performed by a battery diagnosis device according to an embodiment disclosed in this document.
FIG. 7 illustrates a computing system executing a battery diagnosis method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The term "module" as used in various embodiments of this document may include a unit implemented in hardware, software or firmware, and may be used interchangeably with terms such as logic, logic blocks, components, or circuits, for example. The module may be a component that is integrally formed or may be a minimum unit of the component or a part thereof that performs one or more functions. For example, according to an embodiment, the module may be implemented in the form of an application-specific integrated circuit (ASIC).

An embodiment of this document may be implemented as software (e.g., a program) including one or more instructions stored in a machine-readable storage medium. For example, a processor of the machine may call at least one instruction from one or more stored instructions from the storage medium and execute the at least one instruction. This enables the machine to be operated to perform at least one function in response to the at least one instructions that has been called. The one or more instructions may include code generated by a compiler or code executable by an interpreter. The machine-readable storage medium may be provided in the form of a non-transitory storage medium. Here, 'non-transitory' simply means that the storage medium is a tangible device and does not contain signals, and this term does not distinguish between cases where data is stored semi-permanently or temporarily on the storage medium.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration.

According to various embodiments, the operations performed by a module, program, or other component may be performed sequentially, in parallel, repeatedly, or heuristically, or one or more of the operations may be performed in a different order, omitted, or performed by adding one or more other operations.

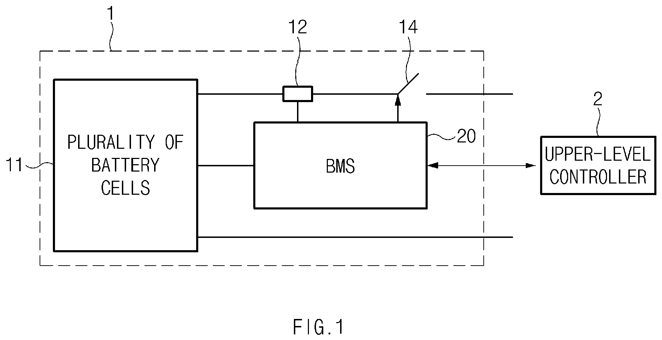

FIG. 1 is a block diagram showing a battery pack according to an embodiment disclosed in this document.

Referring to FIG. 1, a battery control system including a battery pack 1 and an upper-level controller 2 included in an upper-level system according to an embodiment disclosed in this document is schematically illustrated.

As illustrated in FIG. 1, the battery pack 1 may include a plurality of battery cells 11 (or one or more battery cells), a switching unit 14 connected in series to a first terminal side and/or a second terminal side of the plurality of battery cells 11 to control a charge and/or discharge current flow of the plurality of battery cells 11, and a battery management system 20 that monitors the voltage, current, temperature, etc. of the battery pack 1 to prevent overcharging and overdischarging.

In this case, the battery pack 1 may be equipped with a plurality of the plurality of cells 11, sensors 12, switching units 14, and battery management systems 20. For example, a first terminal may be a positive (+) terminal of the plurality of battery cells 11, and a second terminal may be a negative (-) terminal thereof.

Here, the switching unit 14 is a device for controlling the current flow for charging or discharging the plurality of battery cells 11, and for example, at least one relay, magnetic contactor, etc. may be used depending on the specifications of the battery pack 1.

For example, the plurality of battery cells 11 may include a cylindrical battery. The cylindrical battery may refer to a battery in which battery materials are packaged in a cylindrical shape.

The battery management system 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of the plurality of battery cells 11.

The upper-level controller 2 may transmit a control signal for the plurality of battery cells 11 to the battery management system 20. Accordingly, the operation of the battery management system 20 may be controlled based on a signal applied from the upper-level controller 2.

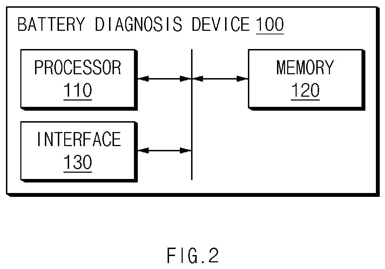

According to the embodiment, the battery management system 20 may include a battery diagnosis device 100 of FIG. 2. According to another embodiment, the battery management system 20 may be another system different from the battery diagnosis device 100 of FIG. 2. That is, the battery diagnosis device 100 of FIG. 2 may be included in the battery pack 1 or may be configured as another device external to the battery pack 1. For convenience of description, it will be described on the premise that the battery diagnosis device 100 is configured as another device external to the battery pack 1.

FIG. 2 is a block diagram illustrating the configuration of a battery diagnosis device according to an embodiment disclosed in this document.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may mean a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. Some of the pieces of hardware of FIG. 2 (e.g., at least a portion of the processor 110, memory 120, and communication circuit (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery diagnosis device 100 according to an embodiment may include hardware components for storing data and/or instructions input and/or output to and from the processor 110. The memory 120 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC). For example, the memory 120 may be configured to store a voltage profile representing a voltage change with respect to a capacity change of a battery cell including an electrode based on a lithium iron phosphate (LFP) material. For example, the LFP material may be contained in the electrode (e.g., the positive electrode) of the battery cell. For example, the battery cell may include the positive electrode containing the LFP material and a negative electrode containing a graphite material.

The interface 130 of the battery diagnosis device 100 according to an embodiment may be configured to generate various battery measurement values from the battery. To this end, the interface 130 may include measuring means such as a voltmeter, ammeter, thermometer, etc., and a communication circuit for establishing a communication link with an external device. As an example, the interface 130 may include a temperature sensor attached to the battery cell.

The battery diagnosis device 100 according to an embodiment may acquire a capacity profile representing a relationship between a capacity and voltage of the battery cell containing the LFP material using the interface 130. The capacity profile may be used in a non-destructive diagnostic method for diagnosing the state of the battery cell without deassembling the battery cell. The capacity profile may represent the relationship between the capacity and voltage of the battery cell that changes while charging or discharging the battery cell. The capacity profile may vary depending on the charging speed or C-rate used for charging the battery cell. For example, the capacity profile may include a differential capacity profile representing the capacity change with respect to the voltage change of the battery cell.

The battery diagnosis device 100 according to an embodiment may divide the entire voltage range included in the capacity profile into one or more voltage ranges.

For example, the battery diagnosis device 100 may distinguish one or more voltage ranges based on identifying the phase transition of the negative electrode. For example, the battery diagnosis device 100 may distinguish one or more voltage ranges based on a peak value indicating the phase transition of the negative electrode.

The battery diagnosis device 100 according to an embodiment may acquire a first differential capacity profile representing a capacity change of a battery cell with respect to a voltage change of the battery cell according to one or more voltage ranges.

For example, the battery diagnosis device 100 may acquire the first differential capacity profile representing the capacity change of the battery cell with respect to the voltage change of the battery cell based on interpolation.

For example, the battery diagnosis device 100 may acquire the capacity change of the battery cell with respect to a voltage change of the battery cell, based on interpolation, using one or more voltage ranges included in the capacity profile. For example, the interpolation may mean a method for estimating a value located between two values in the capacitive profile. For example, the battery diagnosis device 100 may acquire a straight line including two values based on the interpolation. The battery diagnosis device 100 may estimate a value positioned between the two values by acquiring a value included in a straight line based on the interpolation.

For example, the battery diagnosis device 100 may identify two values in each of one or more voltage ranges based on the interpolation. For example, the battery diagnosis device 100 may acquire a different value between the two values using two values identified in each of one or more voltage ranges. The battery diagnosis device 100 may acquire a first differential capacity profile by interpolating the capacity change according to the voltage change using the interpolation.

The battery diagnosis device 100 according to an embodiment may identify positive electrode degradation of the battery cell based on the first differential capacity profile.

The battery diagnosis device 100 according to an embodiment may identify at least one peak in the first differential capacity profile.

For example, at least one peak may represent a phase transition of the negative electrode.

The battery diagnosis device 100 according to an embodiment may identify a first voltage range that includes a voltage exceeding a first voltage value corresponding to at least one peak among one or more voltage ranges.

For example, the first voltage range may be referred to as a high voltage region in terms of including relatively high voltages in the first differential voltage profile. For example, the first voltage range may correspond to a designated SOC region (e.g., 80% or more).

The battery diagnosis device 100 according to an embodiment may identify positive electrode degradation of the battery cell based on the first voltage range.

The battery diagnosis device 100 according to an embodiment may acquire data related to a battery cell in a beginning of life (BoL) state. For example, the battery diagnosis device 100 may acquire a second differential capacity profile representing a capacity change of a battery cell with respect to a voltage change of the battery cell in the BoL state.

For example, the second differential capacity profile may be acquired based on the charging speed and/or C-rate used to acquire the first differential capacity profile.

In an embodiment, the battery diagnosis device 100 may identify a first characteristic section in which a slope of the second differential capacity profile changes in the first voltage range of the second differential capacity profile.

In an embodiment, the battery diagnosis device 100 may identify the positive electrode degradation of the battery cell based on whether a second characteristic section corresponding to the first characteristic section is identified in the first differential capacity profile.

In an embodiment, a characteristic section (e.g., a first characteristic section or a second characteristic section) may be identified according to a shape of the profile (e.g., the first differential capacity profile or the second differential capacity profile). For example, the characteristic section may be identified when a change in the slope of a profile exceeding a designated slope range is acquired. For example, the characteristic section may be identified when a value corresponding to the slope increases after decreasing. For example, the characteristic section may include an inflection point in the profile. The shape of the profile included in the characteristic section may have a form in which the inclination of the slope is relatively alleviated. However, it is not limited thereto.

In an embodiment, when degradation of the LFP material contained in the battery cell progresses, the amount of change in the slope of the profile may increase as the resistance within the battery cell increases. That is, the battery diagnosis device 100 may identify the positive electrode degradation of the battery cell based on the slope of the profile. For example, the battery diagnosis device 100 may identify the positive electrode degradation of the battery cell based on the slope of the first differential capacity profile included in the first voltage range.

The battery diagnosis device 100 according to an embodiment may identify positive electrode degradation of the battery cell exceeding a designated degree of degradation when the second characteristic section is not identified in the first differential capacity profile. The battery diagnosis device 100 according to an embodiment may identify a second voltage value included in the first characteristic section and a first differential capacity value corresponding to the second voltage value in the second differential capacity profile. The battery diagnosis device 100 according to an embodiment may identify a third voltage value corresponding to the second voltage value and a second differential capacity value corresponding to the third voltage value in the first differential capacity profile.

The battery diagnosis device 100 according to an embodiment may identify the positive electrode degradation of the battery cell exceeding the designated degree of degradation when a ratio of the first differential capacity value and the second differential capacity value exceeds the designated degree of degradation.

For example, the ratio of the first differential capacity value and the second differential capacity value may include a difference between the first differential capacity value and the second differential capacity value.

For example, the battery diagnosis device 100 may change the designated degree of degradation according to preset data. However, it is not limited thereto.

The battery diagnosis device 100 according to an embodiment may adjust a charging speed for charging the battery cell based on identifying the positive electrode degradation of the battery cell exceeding the designated degree of degradation. For example, the battery diagnosis device 100 may reduce the charging speed. For example, the battery diagnosis device 100 may adjust an upper limit charging voltage to lower the maximum voltage of the battery cell. However, it is not limited thereto.

The battery diagnosis device 100 according to an embodiment as described above may identify the positive electrode degradation included in the battery cell using the differential capacity profile of the battery cell. For example, the battery diagnosis device 100 may identify the positive electrode degradation of the battery cell based on a designated region (e.g., a first voltage range) of the differential capacity profile. For example, the battery diagnosis device 100 may identify the positive electrode degradation of the battery cell using the change in slope according to the positive electrode degradation using the differential capacity profile. The battery diagnosis device 100 may slow down the progression of the positive electrode degradation by adjusting the charging speed of the battery cell based on identifying the positive electrode degradation.

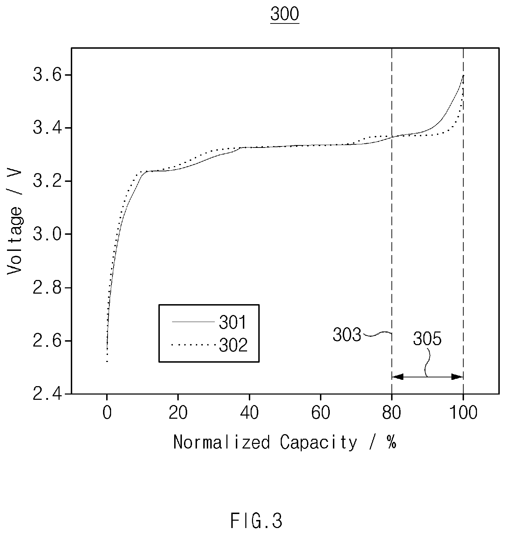

FIG. 3 illustrates an example of a graph representing data related to a battery cell acquired by a battery diagnosis device according to an embodiment disclosed in this document. The battery diagnosis device 100 of FIG. 3 may be referenced to the battery diagnosis device 100 of FIG. 2.

A graph 300 of FIG. 3 may include a first capacity profile 301 and a second capacity profile 302 that represent the relationship between the capacity of a battery cell and the voltage of the battery cell.

For example, the first capacity profile 301 may include data related to a battery cell in a middle of life (MoL) state.

For example, the second capacity profile 302 may include data related to the battery cell in a BoL state.

For example, the battery cell in the MoL state may be included in a state where the positive electrode degradation is relatively more advanced than the battery cell in the BoL state.

The battery diagnosis device 100 according to an embodiment may compare the first capacity profile 301 and the second capacity profile 302 to identify the positive electrode degradation of the battery cell.

For example, the battery diagnosis device 100 may identify a SOC region 305 that exceeds a designated state of charge (SOC) 303 (e.g., approximately 80%). The SOC region 305 may correspond to a high potential region (e.g., a region exceeding 3.4 V).

For example, the battery diagnosis device 100 may compare the slope of the first capacity profile 301 and the slope of the second capacity profile 302 in the SOC region 305.

For example, as the positive electrode degradation progresses, the internal resistance of the battery cell increases, and thus the capacity of the battery cell corresponding to the same voltage may decrease. In the SOC region 305, the slope of the first capacity profile 301 may be smaller than the slope of the second capacity profile 302.

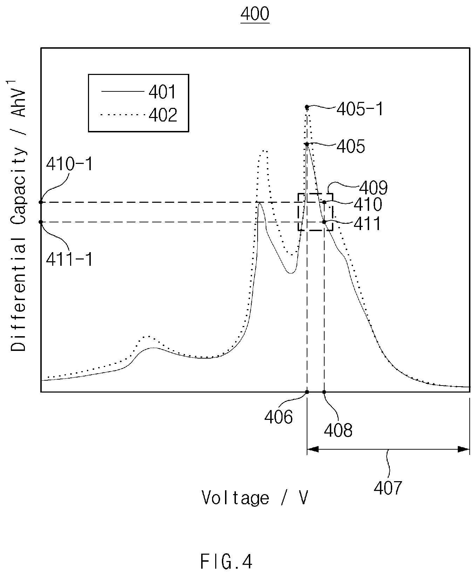

For example, the battery diagnosis device 100 may diagnose the positive electrode degradation of the battery cell using the slope (or the voltage value) of the capacity profile included in a specific region (e.g., the SOC region 305). Hereinafter, with reference to FIG. 4, the operation of the battery diagnosis device 100 using a differential capacity profile to diagnose the positive electrode degradation of a battery cell will be described in more detail.

FIG. 4 illustrates an example of a graph representing a differential capacity profile acquired by a battery diagnosis device according to an embodiment disclosed in this document. The battery diagnosis device 100 of FIG. 4 may be referenced to the battery diagnosis device 100 of FIG. 2. Referring to FIG. 4, a graph 400 may include a first differential capacity profile 401 representing a capacity change of a battery cell with respect to a voltage change of the battery cell in a MoL state, and a second differential capacity profile 402 representing a capacity change of the battery cell with respect to a voltage change of the battery cell in a BoL state.

Referring to FIG. 4, a size (e.g., a differential capacity value) of the first differential capacity profile 401 according to an embodiment may be relatively smaller than the size of the second differential capacity profile 402. Since the battery cell in the MoL state has undergone relatively more degradation than the battery cell in the BoL state, the size (e.g., the differential capacity value) of the first differential capacity profile 401 may be relatively smaller than the size of the second differential capacity profile 402. For example, the size of the differential capacity profile (e.g., the differential capacity value) may be related to the degradation of the negative electrode of the battery cell.

The battery diagnosis device 100 according to an embodiment may divide the entire voltage range included in the first differential capacity profile 401 into one or more voltage ranges.

For example, the battery diagnosis device 100 may identify at least one peak 405 included in the first differential capacity profile 401. For example, the battery diagnosis device 100 may identify a first voltage range 407 that includes a voltage that exceeds a first voltage value 406 corresponding to at least one peak 405 of one or more voltage ranges. For example, the first voltage range 407 may correspond to the SOC region 305 of FIG. 3.

For example, the battery diagnosis device 100 may identify at least one peak 405-1 included in the second differential capacity profile 402. For example, the battery diagnosis device 100 may identify a second voltage range that includes a voltage that exceeds the voltage value (e.g., the first voltage value 406) corresponding to at least one peak 405-1 of one or more voltage ranges. For example, the second voltage range may correspond to the first voltage range 407.

The battery diagnosis device 100 according to an embodiment may identify a first characteristic section 409 in which the slope of the second differential capacity profile changes in the first voltage range 407 of the second differential capacity profile 402. For example, the battery diagnosis device 100 may identify the positive electrode degradation of the battery cell based on whether a second characteristic section corresponding to the first characteristic section 409 is identified in the first differential capacity profile 401.

For example, the first characteristic section 409 may represent a section of change in the slope of the profile that exceeds a designated slope range. For example, the first characteristic section 409 may include an inflection point (e.g., a peak value 410). However, it is not limited thereto. The first characteristic section 409 may exhibit characteristics in which the size of the slope decreases and then increases.

For example, the second differential capacity profile may include a section of change in the slope of the profile included in the designated slope range in the first voltage range 407. That is, the second differential capacity profile 40) may not have the second characteristic section corresponding to the first characteristic section 409.

For example, when the second characteristic section is not identified in the first differential capacity profile 401, the battery diagnosis device 100 may identify the positive electrode degradation of a battery cell exceeding a designated degree of degradation.

For example, when the second characteristic section is identified in the first differential capacity profile 401, the battery diagnosis device 100 may identify the positive electrode degradation of the battery cell that is less than the designated degree of degradation. That is, when the battery diagnosis device 100 identifies the second characteristic section corresponding to the first characteristic section 409, the battery diagnosis device 100 may not initiate processing of an operation for alleviating the positive electrode degradation of the battery cell.

The battery diagnosis device 100 according to an embodiment may identify a second voltage value 408 included in the first characteristic section 409 and a first differential capacity value 410-1 corresponding to the second voltage value 408 in the second differential capacity profile 402.

The battery diagnosis device 100 according to an embodiment may identify a third voltage value corresponding to the second voltage value 408 included in the first characteristic section 409. The third voltage value may be included in the second voltage value 408. For example, the battery diagnosis device 100 may identify the third voltage value and a second differential capacity value 411-1 corresponding to the third voltage value.

For example, the battery diagnosis device 100 may identify at least one point 411 corresponding to the second voltage value 408 in the first differential capacity profile 401. Based on identifying the profile value 411, the battery diagnosis device 100 may identify the second differential capacity value 411-1.

When a ratio of the first differential capacity value 410-1 and the second differential capacity value 411-1 exceeds a designated degree of degradation, the battery diagnosis device 100 according to an embodiment may identify the positive electrode degradation of the battery cell. For example, the battery diagnosis device 100 may identify the positive electrode degradation of the battery cell using a difference between the first differential capacity value 411-1 and the second differential capacity value 410-1.

For example, when the battery diagnosis device 100 identifies the positive electrode degradation of the battery cell that exceeds the designated degree of degradation, the battery diagnosis device 100 may adjust the charging speed for charging the battery cell. However, it is not limited thereto.

Referring to FIG. 4, although the differential capacity profile related to the charging of the battery cell has been described, it is obvious that the battery diagnosis device 100 may diagnose the positive electrode degradation of the battery cell using the differential capacity profile related to discharging of the battery cell.

The battery diagnosis device 100 according to an embodiment as described above may diagnose the positive electrode degradation of the battery cell using the differential capacity value corresponding to the designated voltage value (e.g., the second voltage value 408). The battery diagnosis device 100 may alleviate the non-uniformity within the battery cell by diagnosing the positive electrode degradation of the battery cell using the differential capacity profile. When a battery cell degrades, it may have a region (e.g., a negative electrode) where particles within the battery cell reacted relatively much. The battery battery diagnosis device 100 may slow down degradation of of the battery cell by adjusting the charging speed to alleviate non-uniformity within the battery cell.

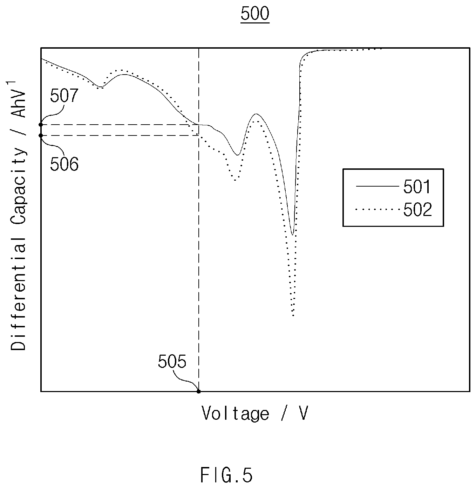

FIG. 5 illustrates an example of a graph showing a differential capacity profile according to discharging of a battery cell according to an embodiment disclosed in this document. The battery diagnosis device 100 of FIG. 5 may be referenced to the battery diagnosis device 100 of FIG. 2. Referring to FIG. 5, a graph 500 may include a first differential capacity profile 501 and a second differential capacity profile 502 acquired while discharging a battery cell.

For example, the first differential capacity profile 501 may represent a capacity change with respect to voltage change of a battery cell in a MoL state. The second differential capacity profile 502 may represent a capacity change with respect to voltage change of the battery cell in a BoL state.

The battery diagnosis device 100 according to an embodiment may identify a voltage value 505 related to the degradation of the positive electrode among the positive electrode and negative electrode of the battery cell through pre-designated data.

For example, the battery diagnosis device 100 may identify a first differential capacity value 507 corresponding to the voltage value 505 in the first differential capacity profile 501.

For example, the battery diagnosis device 100 may identify a second differential capacity value 506 corresponding to the voltage value 505 in the second differential capacity profile 502.

The battery diagnosis device 100 according to an embodiment may diagnose the positive electrode degradation of the battery cell according to a ratio of the first differential capacity value 507 and the second differential capacity value 506.

For example, when the ratio exceeds a designated degree of degradation, the battery diagnosis device 100 may identify the positive electrode degradation of the battery cell. For example, the battery diagnosis device 100 may adjust the charging speed for charging the battery cell based on identifying the positive electrode degradation of the battery cell.

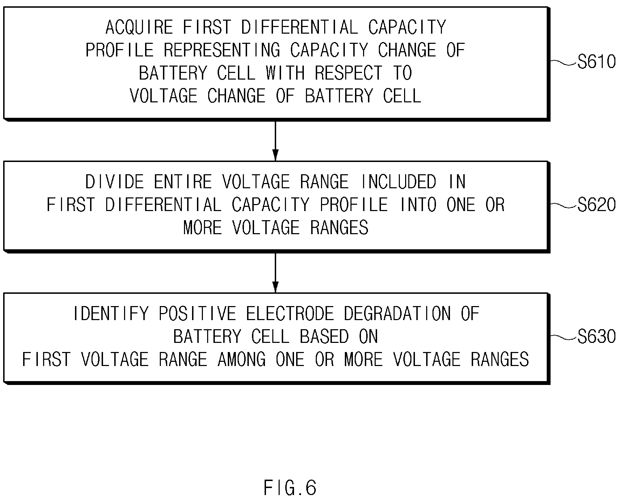

FIG. 6 illustrates an example of a flowchart showing operations performed by a battery diagnosis device according to an embodiment disclosed in this document. Hereinafter, it is assumed that the battery diagnosis device 100 of FIG. 2 performs the process of FIG. 6. In addition, the operations described as being performed by the device may be understood to be controlled by the processor 110 of the battery diagnosis device 100. Each of the operations of FIG. 6 may be performed sequentially, but they are not necessarily performed sequentially. For example, the order of each of the actions may be changed, and at least two operations may be performed in parallel. In addition, the operation of the battery diagnosis device 100 may be performed by a battery management system (BMS) in the vehicle, as well as by various devices such as a server, cloud, charger, or charger/discharger.

In operation S610, the battery diagnosis device 100 according to an embodiment may acquire a first differential capacity profile (e.g., the first differential capacity profile 401 of FIG. 4) representing a capacity change of a battery cell with respect to a voltage change of the battery cell.

In operation S620, the battery diagnosis device 100 according to an embodiment may divide the entire voltage range included in the first differential capacity profile into one or more voltage ranges.

For example, the battery diagnosis device 100 may identify a first voltage range (e.g., the first voltage range 407 of FIG. 4) that includes a voltage exceeding a voltage value (e.g., the first voltage value 406) corresponding to at least one peak (e.g., at least one peak 405 of FIG. 4) among one or more voltage ranges.

In operation S630, battery diagnosis device 100 according to an embodiment may identify the positive electrode degradation of the battery cell based on the first voltage range among one or more voltage ranges.

For example, the battery diagnosis device may identify the positive electrode degradation of the battery cell based on the slope of the first differential capacity profile in the first voltage range.

For example, when the battery diagnosis device 100 identifies the positive electrode degradation of the battery cell that exceeds a designated degree of degradation, the battery diagnosis device may reduce the charging speed for charging the battery cell.

For example, when the battery diagnosis device identifies the positive electrode degradation of the battery cell that exceeds a designated degree of degradation, the battery diagnosis device may limit the upper limit charging voltage of the battery cell.

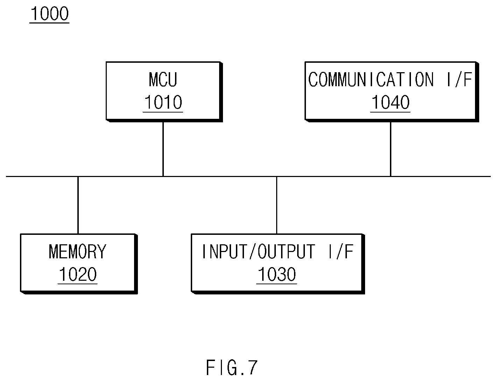

FIG. 7 illustrates a computing system executing a battery diagnosis method according to an embodiment disclosed in this document.

Referring to FIG. 7, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data including the state of charge (SOC), state of health (SOH), etc. of a plurality of battery cells through these programs, and performs the functions of the battery diagnosis device 100 described above. The MCU 1010 may be, but is not limited to, a BMS, a separate PC, or the cloud.

The memory 1020 may store various programs related to calculating the SOH of battery cells and determining the target for cell balancing. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, a program or various data for calculating the SOH of a battery cell or determining a balancing target may be transmitted to and received from a separately provided external server through the communication I/F 1040.

In this way, the battery diagnosis method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
an interface configured to acquire a capacity profile representing a voltage with respect to a capacity of a battery cell including an electrode based on a lithium iron phosphate (LFP) material; and
at least one processor,
wherein the at least one processor is configured to:
acquire a first differential capacity profile representing a capacity change of the battery cell with respect to a voltage change of the battery cell;
divide an entire voltage range included in the first differential capacity profile into one or more voltage ranges; and
identify positive electrode degradation of the battery cell based on a first voltage range among the one or more voltage ranges.

2. The battery diagnosis device of claim 1, wherein the at least one processor is configured to:
identify at least one peak included in the first differential capacity profile;
identify the first voltage range including a voltage exceeding a first voltage value corresponding to the at least one peak among the one or more voltage ranges; and
identify the positive electrode degradation of the battery cell based on the first voltage range.

3. The battery diagnosis device of claim 2, wherein the at least one processor is configured to:
acquire a second differential capacity profile representing the capacity change of the battery cell with respect to the voltage change of the battery cell in a beginning of life (BoL) state;
identify a first characteristic section in which a slope of the second differential capacity profile changes in the first voltage range of the second differential capacity profile; and
identify the positive electrode degradation of the battery cell based on whether a second characteristic section corresponding to the first characteristic section is identified in the first differential capacity profile.

4. The battery diagnosis device of claim 3, wherein the at least one processor is configured to identify the positive electrode degradation of the battery cell exceeding a designated degree of degradation when the second characteristic section is not identified in the first differential capacity profile.

5. The battery diagnosis device of claim 4, wherein the at least one processor is configured to:
identify a second voltage value included in the first characteristic section and a first differential capacity value corresponding to the second voltage value in the second differential capacity file;
identify a third voltage value corresponding to the second voltage value and a second differential capacity value corresponding to the third voltage value in the first differential capacity file;
identify the positive electrode degradation of the battery cell exceeding the designated degree of degradation when a ratio of the first differential capacity value and the second differential capacity value exceeds the designated degree of degradation; and
adjust a charging speed for charging the battery cell based on identifying the positive electrode degradation of the battery cell that exceeds the degree of degradation.

6. The battery diagnosis device of claim 3, wherein the at least one processor is configured to identify the positive electrode degradation of the battery cell that is less than the designated degree of degradation when the second characteristic section is identified in the first differential capacity profile.

7. The battery diagnosis device of claim 2, wherein the at least one processor is configured to identify the positive electrode degradation of the battery cell based on a slope of the first differential capacity profile included in the first voltage range.

8. The battery diagnosis device of claim 2, wherein the at least one peak indicates a phase transition of a negative electrode of the battery cell.

9. The battery diagnosis device of claim 1, wherein the at least one processor is configured to acquire the first differential capacity profile representing the capacity change of the battery cell with respect to the voltage change of the battery cell according to the one or more voltage ranges, based on interpolation.

10. A battery diagnosis method comprising:
an operation of acquiring a first differential capacity profile representing a capacity change of a battery cell including an electrode based on a lithium iron phosphate (LFP) material with respect to a voltage change of the battery cell;
an operation of dividing an entire voltage range included in the first differential capacity profile into one or more voltage ranges; and
an operation of identifying positive electrode degradation of the battery cell based on a first voltage range among the one or more voltage ranges.

11. The battery diagnosis method of claim 10, wherein the operation of identifying the positive electrode degradation of the battery cell includes:
an operation of identifying at least one peak included in the first differential capacity profile;
an operation of identifying the first voltage range including a voltage exceeding a first voltage value corresponding to the at least one peak among the one or more voltage ranges; and
an operation of identifying the positive electrode degradation of the battery cell based on the first voltage range.

12. The battery diagnosis method of claim 11, wherein the operation of identifying the positive electrode degradation of the battery cell includes:
an operation of acquiring a second differential capacity profile representing the capacity change of the battery cell with respect to the voltage change of the battery cell in a beginning of life (BoL) state;
an operation of identifying a first characteristic section in which a slope of the second differential capacity profile changes in the first voltage range of the second differential capacity profile; and
an operation of identifying the positive electrode degradation of the battery cell based on whether a second characteristic section corresponding to the first characteristic section is identified in the first differential capacity profile.

13. The battery diagnosis method of claim 12, wherein the operation of identifying the positive electrode degradation of the battery cell includes an operation of identifying the positive electrode degradation of the battery cell exceeding a designated degree of degradation when the second characteristic section is not identified in the first differential capacity profile.

14. The battery diagnosis method of claim 13, wherein the operation of identifying the positive electrode degradation of the battery cell exceeding the designated degree of degradation includes:
an operation of identifying a second voltage value included in the first characteristic section and a first differential capacity value corresponding to the second voltage value in the second differential capacity file;
an operation of identifying a third voltage value corresponding to the second voltage value and a second differential capacity value corresponding to the third voltage value in the first differential capacity file;
an operation of identifying the positive electrode degradation of the battery cell exceeding the designated degree of degradation when a ratio of the first differential capacity value and the second differential capacity value exceeds the designated degree of degradation; and
an operation of adjusting a charging speed for charging the battery cell based on identifying the positive electrode degradation of the battery cell that exceeds the degree of degradation.

15. The battery diagnosis method of claim 12, wherein the operation of identifying the positive electrode degradation of the battery cell includes an operation of identifying the positive electrode degradation of the battery cell that is less than the designated degree of degradation when the second characteristic section is identified in the first differential capacity profile.
